# FASCICULE DE BREVET EUROPEEN

(11) **EP 0 768 674 B1**
(45) Date de publication et mention de la délivrance du brevet: **08.07.1998**
(21) Numéro de dépôt: 96402201.6
(22) Date de dépôt: 15.10.1996
(51) Int. Cl.: G11C 19/00, G11C 19/28

(54) **Procédé d'initialisation d'un registre à décalage et registre associé**
Initialisierungsprozess eines Schieberegisters und dazugehöriges Register
Initialization process of a shift register and related register

(30) Priorité: 16.10.1995 FR 9512104
(43) Date de publication de la demande: 16.04.1997
(73) Titulaire: SGS-THOMSON MICROELECTRONICS S.A., 94250 Gentilly (FR)
(72) Inventeur: Wuidart, Sylvie, Cabinet Ballot-Schmit, 94230 Cachan (FR)
(74) Mandataire: Schmit, Christian Norbert Marie

(56) Documents cités:
- EP-A- 0 138 406
- EP-A- 0 224 004
- US-A- 5 202 908

## Description

L'invention concerne l'initialisation d'un registre à décalage ou plus généralement, d'un groupe de cellules mémoires synchrones et non transparentes en série. Elle s'applique plus particulièrement à l'initialisation de longs registres, tels ceux par exemple utilisés dans des applications de cryptographie, notamment dans le domaine des cartes à microcircuits.

Une cellule synchrone non transparente d'un registre à décalage comprend habituellement un étage d'entrée et un étage de sortie, contrôlés au moyen de deux signaux d'horloge en opposition de phase.

Ces signaux sont appliqués à des portes de transfert des données de chaque étage. L'un des deux signaux commande le maintien d'une donnée dans l'étage d'entrée et son transfert vers l'étage de sortie. L'autre commande l'entrée d'une nouvelle donnée dans l'étage d'entrée et le maintien de la donnée précédente dans l'étage de sortie.

Un registre à décalage, comme celui de la figure 1 du document US-A-5 202 908, est habituellement initialisé en introduisant, au niveau de chaque cellule qui le constitue, un circuit apte à imposer un zéro en sortie lorsqu'un signal d'initialisation est activé. Ce circuit utilise généralement des portes logiques, en synchronisation avec les signaux de commande du registre.

En pratique, au moins un à deux transistors supplémentaires doivent être prévus dans l'étage d'entrée et l'étage de sortie de chaque cellule, pour assurer cette fonction d'initialisation. Aussi, le circuit d'initialisation devient-il vite encombrant au-delà d'une certaine longueur du registre. Par exemple, pour un registre de 1024 cellules, il faut au moins 4096 transistors en plus.

La synchronisation du signal d'initialisation avec les signaux de commande du registre introduit un retard dans l'exécution de la ré-initialisation.

En outre, ce circuit d'initialisation nécessite le transport du signal jusqu'à chaque cellule. Au-delà d'une certaine longueur du registre, la perte de temps imputable au temps de propagation de l'état actif du signal d'initialisation jusqu'à chaque cellule ne devient plus du tout négligeable.

Or il est important pour certaines applications des registres à décalage de pouvoir presque instantanément ré-initialiser leurs contenus, pour ne pas "exposer" les données sensibles qu'ils peuvent contenir. C'est notamment le cas pour les applications de cryptographie et aussi parce que l'on cherche à travailler à plus grande vitesse.

Un objet de l'invention est donc un procédé d'initialisation qui permet une initialisation instantanée du registre à décalage.

Un autre objet de l'invention est un circuit d'initialisation d'un registre à décalage très peu encombrant.

Un autre objet de l'invention est un circuit d'initialisation qui permet une initialisation non synchrone du fonctionnement du registre à décalage, ce qui permet son exécution immédiate, sans retard.

Telle que caractérisée, l'invention concerne donc un procédé d'initialisation d'un groupe de cellules mémoires synchrones non transparentes en série, comportant des portes de transfert commandées par au moins deux signaux d'horloge en opposition de phase pour bloquer certaines de ces portes et rendre passantes les autres et inversement.

Selon l'invention, ce procédé consiste à modifier ces signaux d'horloge sur activation d'un signal de ré-initialisation pour forcer toutes les portes de transfert à l'état passant.

L'invention concerne aussi un registre à décalage comportant des cellules mémoires synchrones non transparentes en série, commandées par au moins deux signaux d'horloge en opposition de phase, lesdites cellules comportant des portes de transfert recevant chacune au moins l'un des deux signaux d'horloge pour être bloquée ou rendue passante selon que l'on mémorise une nouvelle donnée dans chaque cellule ou que l'on transfère une donnée mémorisée en sortie de chaque cellule. Selon l'invention, ce registre comprend un circuit d'initialisation pour rendre transparentes toutes les cellules dudit registre dans une phase d'initialisation, ledit circuit comprenant au moins une porte logique pour modifier les deux signaux d'horloge pendant l'état actif d'un signal d'initialisation.

D'autres avantages et caractéristiques de l'invention sont détaillés dans la description suivante faite à titre indicatif et nullement limitatif de l'invention et en référence aux dessins annexés dans lesquels :
- la figure 1 représente un exemple de structure d'une cellule d'un registre à décalage avec un circuit d'initialisation selon l'invention et
- la figure 2 est un diagramme des temps des signaux correspondants montrant le fonctionnement normal et la phase d'initialisation.

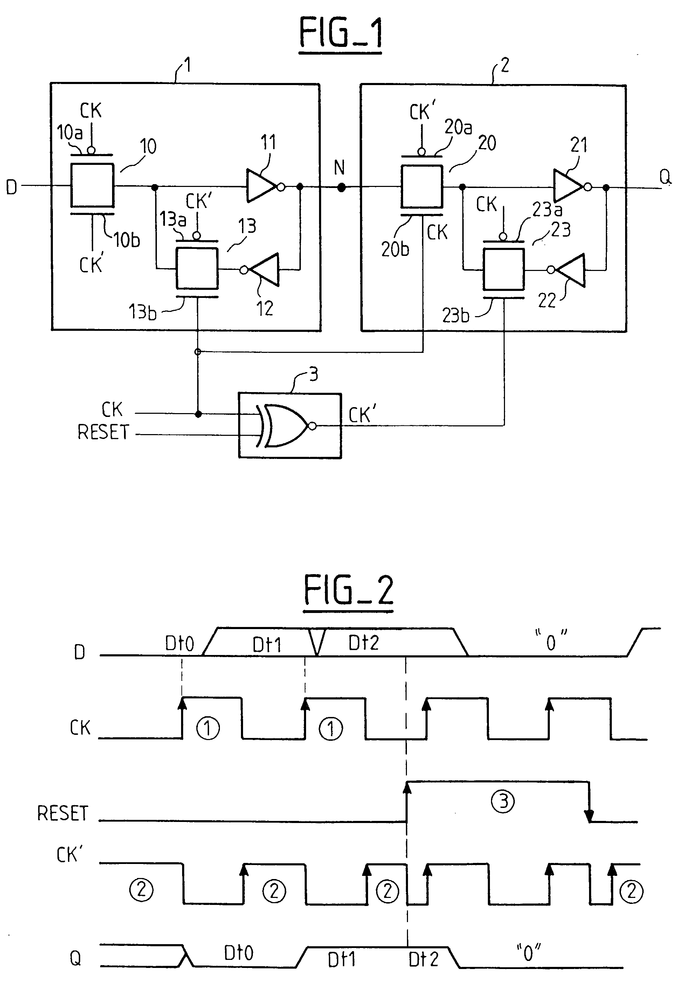

La figure 1 représente un exemple de structure d'un registre à décalage. Cette structure n'est donnée qu'à titre d'exemple non exhaustif, pour illustrer l'invention.

Une cellule synchrone et non transparente d'un registre à décalage comprend habituellement un étage d'entrée 1 et un étage de sortie 2 commandés par au moins deux signaux d'horloge CK et CK' en opposition de phase (CK' = /CK).

L'étage d'entrée a une entrée D et un noeud de sortie N connecté en entrée de l'étage de sortie. La sortie de l'étage de sortie est notée Q. Ces deux étages comportent des portes de transfert commandées par les deux signaux d'horloge.

Le principe de fonctionnement comme illustré sur la figure 2 est bien connu. Il peut être explicité comme suit :
Phase ① : quand le premier signal d'horloge CK est actif (CK=1), l'étage d'entrée est isolé de son entrée D et transmet sur le noeud N la donnée précédemment mémorisée Dt_{O}. L'étage de sortie transmet cette donnée sur sa sortie Q.
Phase ② : quand c'est l'autre signal d'horloge qui est actif (CK'=1), l'étage d'entrée mémorise la nouvelle donnée Dt₁ présente sur son entrée D, tandis que l'étage de sortie est isolé du noeud N et maintient sur sa sortie Q la donnée Dtₒ.

Selon l'invention, on prévoit un circuit d'initialisation pour modifier les signaux d'horloge CK et CK' pendant l'état actif d'un signal de ré-initialisation, de manière à forcer les deux étages dans un mode transparent, pour initialiser instantanément la cellule avec une donnée d'initialisation.

En pratique, en présentant la donnée d'initialisation sur l'entrée D de la première cellule d'un registre, puis en activant le signal de ré-initialisation reset, le circuit d'initialisation force les deux signaux d'horloge appliqués à toutes les cellules dans un état modifié, en sorte que toutes les portes de transfert de toutes les cellules soient passantes : les cellules du registre sont alors en mode transparent et s'initialisent très vite.

Le signal de reset n'a plus à être propagé : il modifie les signaux d'horloge du registre pour en modifier le fonctionnement.

Le temps d'initialisation correspond alors essentiellement au temps de transfert de la donnée dans un mode de fonctionnement monophasé du registre (puisque tous les étages d'entrée et de sortie sont en mode de transfert).

Dans l'exemple plus particulièrement représenté sur la figure 1, l'étage d'entrée 1 comprend une première porte de transfert 10 connectée à l'entrée D de la cellule. La porte de transfert 10 est suivie d'un premier inverseur 11 dont la sortie constitue le noeud N de sortie de l'étage d'entrée. La sortie de l'inverseur 11 est rebouclée sur son entrée par un deuxième inverseur 12 en série avec une deuxième porte de transfert 13. L'ensemble constitué par les deux inverseurs et la porte de transfert forme une boucle de mémorisation, avec un premier inverseur 11 peu résistif (fort) et un deuxième inverseur 12 très résistif.

L'étage de sortie 2 a une structure similaire. Il est connecté en entrée au noeud N et il transmet les données sur sa sortie Q.

La première porte de transfert, le premier inverseur, le deuxième inverseur et la deuxième porte de transfert de cet étage de sortie ont respectivement pour références : 20, 21, 22 et 23.

Dans l'exemple représenté, les portes de transfert sont à double commande. Elles comportent deux transistors MOS en parallèle, de conductivités opposées. La porte de transfert 10 comprend ainsi un transistor MOS de type P noté 10a et un transistor MOS de type N noté 10b. En mode opérationnel les deux transistors d'une porte de transfert sont commandés en opposition de phase, pour être passants en même temps et isolants en même temps. Ainsi, dans l'exemple, les portes de transfert 10 et 23 reçoivent le signal d'horloge CK sur la grille de leur transistor P (10a et 23a) et le signal d'horloge CK' sur la grille de leur transistor N (10b et 23b). De cette manière, ces portes sont bloquées pendant la phase ① de transfert de la donnée Dto mémorisée, vers la sortie Q de l'étage de sortie. Elles sont passantes pendant la phase ② de mémorisation d'une nouvelle donnée Dt1 présentée sur l'entrée D.

Les portes de transfert 13 et 20 reçoivent quant à elles le signal d'horloge CK' sur la grille de leur transistor P (13a et 20a) et le signal d'horloge CK sur la grille de leur transistor N (13b et 20b).

De cette manière, ces portes sont passantes pendant la phase ① de transfert et bloquées pendant la phase ② de mémorisation.

Les portes de transfert 10 et 23 fonctionnent donc à l'inverse des portes de transfert 13 et 20.

Selon l'invention, on prévoit que l'activation d'un signal de ré-initialisation (reset = 1) modifie les deux signaux d'horloges CK et CK' pour forcer toutes les portes de transfert à l'état passant : une donnée présente en entrée est transmise directement sur la sortie Q via la porte 10, l'inverseur 11, la porte 20 et l'inverseur 21.

Dans l'exemple, il suffit pour cela de mettre en phase les signaux d'horloge CK et CK' (CK=CK' quand reset = 1). En effet, comme les portes de transfert comportent ici 2 transistors de types de conductivité opposés, il y en aura toujours un qui sera passant : le transistor P quand CK = CK'= O et le transistor N quand CK = CK' = 1.

Si les portes de transfert ne comportaient qu'un seul transistor, il suffirait pour mettre en oeuvre l'invention de forcer les signaux d'horloge CK et CK' à un état actif approprié (O ou 1) pendant le temps d'initialisation pour rendre passantes toutes les portes de transfert.

En pratique, pour modifier les signaux d'horloge CK et CK' selon l'invention, pour rendre passantes toutes les portes de transfert des cellules du registre, il suffit d'utiliser comme circuit d'initialisation 3, une ou plusieurs portes logiques.

Dans l'exemple représenté sur la figure 1, où il s'agit, pour obtenir le fonctionnement en mode transparent selon le procédé d'initialisation de l'invention, d'avoir des signaux d'horloge CK et CK' en phase pendant la ré-initialisation et en opposition de phase autrement, une simple porte NOR EXCLUSIF suffit. Cette porte reçoit en entrées le signal de ré-initialisation reset et un signal d'horloge (par exemple CK) et délivre en sortie l'autre signal d'horloge (dans l'exemple CK'). Le signal d'horloge qui sert à générer l'autre est classiquement obtenu d'un circuit de génération d'horloge (oscillateur et diviseur) non représenté.

L'invention qui consiste à forcer les portes de transfert à l'état passant en modifiant les signaux d'horloge qui les commandent s'applique à toutes les structures diverses de registre à décalage. Toutes les réalisations qui en découlent restent du domaine de l'invention.

## Revendications

1. Procédé d'initialisation d'un groupe de cellules mémoires synchrones non transparentes en série (1,2), comportant des portes de transfert (10,13) commandées par au moins deux signaux d'horloge (CK, CK') en opposition de phase pour bloquer certaines de ces portes et rendre passantes les autres et inversement, caractérisé en ce qu'il consiste à modifier ces signaux d'horloge (CK,CK') sur activation d'un signal de ré-initialisation (RESET) pour forcer toutes les portes de transfert à l'état passant.

2. Procédé d'initialisation selon la revendication 1, pour des portes de transfert (10) à au moins deux transistors (10a, 10b) commandés par deux signaux d'horloge en opposition de phase (CK,CK'), caractérisé en ce qu'il consiste à mettre en phase les deux signaux d'horloge (CK,CK') sur activation du signal de ré-initialisation (RESET).

3. Registre à décalage comportant des cellules mémoires synchrones non transparentes en série (1,2), commandées par au moins deux signaux d'horloge en opposition de phase (CK,CK'), lesdites cellules comportant des portes de transfert (10,13) recevant chacune au moins l'un des deux signaux d'horloge (CK ou CK') pour être bloquée ou rendue passante selon que l'on mémorise une nouvelle donnée dans chaque cellule ou que l'on transfère une donnée mémorisée en sortie de chaque cellule, caractérisé en ce qu'il comprend un circuit d'initialisation (3) pour rendre transparentes toutes les cellules dudit registre dans une phase d'initialisation, ledit circuit comprenant au moins une porte logique pour modifier les deux signaux d'horloge pendant l'état actif d'un signal de ré-initialisation (RESET).

4. Registre à décalage selon la revendication 3, pour des portes de transfert à au moins deux transistors commandés par deux signaux d'horloge en opposition de phase (CK,CK'), caractérisé en ce que le circuit d'initialisation comprend une porte logique de type NON OU EXCLUSIF recevant en entrée un des signaux d'horloge (CK ou CK') et le signal de ré-initialisation (RESET) pour délivrer en sortie l'autre signal d'horloge en phase avec le premier sur l'état actif du signal de ré-initialisation (RESET) et en opposition de phase sur l'état inactif du signal de ré-initialisation (RESET).

5. Circuit intégré comprenant au moins un registre à décalage selon l'une quelconque des revendications 3 à 4.

6. Carte à microcircuits, comprenant au moins un circuit intégré selon la revendication 5.

## Claims

1. Method of init-ialising a group of non-transparent synchronous memory cells in series (1, 2), comprising transfer gates (10, 13) controlled by at least two clock signals (CK, CK') in phase opposition in order to block some of these gates and make the others conducting and vice versa, characterised in that it consists of modifying these clock signals (CK, CK') on activation of a reinitialisation signal (RESET) in order to force all the transfer gates to the conducting state.

2. Initialisation method according to Claim 1, for transfer gates (10) with at least two transistors (10a, 10b) controlled by two clock signals in phase opposition (CK, CK'), characterised in that it consists of putting the two clock signals (CK, CK') in phase on activation of the reinitialisation signal (RESET) .

3. Shift register having non-transparent synchronous memory cells in series (1, 2), controlled by at least two clock signals in phase opposition (CK, CK'), the said cells having transfer gates (10, 13) each receiving at least one of the two clock signals (CK or CK') in order to be blocked or made conducting depending on whether a new data item is stored in each cell or a stored data item is transferred as an output from each cell, characterised in that it comprises an initialisation circuit (3) for making transparent all the cells of the said register in an initialisation phase, the said circuit comprising at least one logic gate for modifying the two clock signals during the active state of a reinitialisation signal (RESET).

4. Shift register according to Claim 3, for transfer gates with at least two transistors controlled by two clock signals in phase opposition (CK, CK'), characterised in that the initialisation circuit comprises a logic gate of the exclusive NOR type receiving as an input one of the clock signals (CK or CK') and the reinitialisation signal (RESET) in order to deliver as an output the other clock signal in phase with the first one at the active state of the reinitialisation signal (RESET) and in phase opposition at the inactive state of the reinitialisation signal (RESET) .

5. Integrated circuit comprising at least one shift register according to either one of Claims 3 to 4.

6. Microcircuit card comprising at least one integrated circuit according to Claim 5.

## Patentansprüche

1. Verfahren zum Initialisieren einer Gruppe von synchronen und nicht transparenten Speicherzellen in Reihe (1, 2), die Übertragungsgatter (10, 13) umfassen, welche durch wenigstens zwei Taktsignale (CK, CK') mit entgegengesetzter Phase zum Sperren einiger der Gatter und Durchschalten der anderen und umgekehrt gesteuert werden, dadurch gekennzeichnet, daß
es darin besteht, die Taktsignale (CK, CK') bei Aktivierung eines Reinitialisierungssignals (RESET) zu modifizieren, um alle Übertragungsgatter in den durchgeschalteten Zustand zu bringen.

2. Initialisierungsverfahren nach Anspruch 1 für Übertragungsgatter (10) mit wenigstens zwei Transistoren (10a, 10b), die durch zwei Taktsignale mit entgegengesetzter Phase (CK, CK') angesteuert werden, dadurch gekennzeichnet, daß es darin besteht, die zwei Taktsignale (CK, CK') bei Aktivierung des Reinitialisierungssignals (RESET) in Phase zu bringen.

3. Schieberegister mit synchronen und nicht transparenten Speicherzellen in Reihe (1, 2), die durch wenigstens zwei Taktsignale mit entgegengesetzter Phase (CK, CK') angesteuert werden, wobei die Zellen Übertragungsgatter (10, 13) umfassen, welche jeweils mindestens eines der zwei Taktsignale (CK oder CK') empfangen, so daß sie gesperrt werden oder durchgeschaltet werden, bei dem eine neue Dateneinheit in jeder Zelle abgelegt wird oder eine abgelegte Dateneinheit am Ausgang jeder Zelle übertragen wird, dadurch gekennzeichnet, daß es einen Initialisierungsschaltkreis (3) zum Durchschalten aller Zellen des Registers während einer Initialisierungsphase umfaßt, wobei der Schaltkreis wenigstens ein Logikgatter umfaßt, um die zwei Taktsignale während des aktiven Zustandes eines Reinitialisierungssignals (RESET) zu modifizieren.

4. Schieberegister nach Anspruch 3 für Übertragungsgatter mit wenigstens zwei Transistoren, die durch zwei Taktsignale mit entgegengesetzter Phase (CK, CK') angesteuert werden, dadurch gekennzeichnet, daß der Initialisierungsschaltkreis ein Logikgatter vom Nicht-Exklusiv-Oder-Typ umfaßt, das am Eingang eines der Taktsignale (CK oder CK') und das Reinitialisierungssignal (RESET) empfängt, um am Ausgang das andere Taktsignal in Phase mit dem ersten bei aktivem Zustand des Reinitialisierungssignals (RESET) und mit entgegengesetzter Phase beim inaktiven Zustand des Reinitialisierungssignals (RESET) auszugeben.

5. Integrierter Schaltkreis mit wenigstens einem Schieberegister nach einem der Ansprüche 3 und 4.

6. Mikrochipkarte mit wenigstens einem integrierten Schaltkreis nach Anspruch 5.
